Europäisches Patentamt

European Patent Office

Office européen des brevets

(11) Veröffentlichungsnummer : **0 054 981**
**B1**

(12) **EUROPÄISCHE PATENTSCHRIFT**

(45) Veröffentlichungstag der Patentschrift :
04.07.84

(21) Anmeldenummer : 81201184.9

(22) Anmeldetag : 27.10.81

(51) Int. Cl.³ : **H 03 F   1/06**

(54) **Verstärkerschaltung für niederfrequente Modulationssignale eines Rundfunksenders.**

(30) Priorität : 12.12.80 CH 9173/80

(43) Veröffentlichungstag der Anmeldung :
30.06.82 Patentblatt 82/26

(45) Bekanntmachung des Hinweises auf die Patenter-
teilung : 04.07.84 Patentblatt 84/27

(84) Benannte Vertragsstaaten :
CH DE FR GB LI

(56) Entgegenhaltungen :
CH-A-   422 899
FR-A- 2 197 267
GB-A-   444 050

(73) Patentinhaber : BBC Aktiengesellschaft Brown,
Boveri & Cie.
Haselstrasse
CH-5401 Baden (CH)

(72) Erfinder : Kyrian, Bohumil, Dipl.-Ing.
Dammstrasse 36
CH-5200 Windisch (CH)

Beschreibung

Die Erfindung betrifft eine Verstärkerschaltung für niederfrequente Modulationssignale eines Rundfunksenders gemäss dem Oberbegriff des Anspruchs 1.

Bei einem Modulationsverstärker für hohe Ausgangsleistung soll die zugeführte Gleichstromleistung mit möglichst hohem Wirkungsgrad in Ausgangsleistung umgeformt werden. Für sehr hohe Ausgangsleistungen werden fast ausnahmslos Gegentaktverstärker im sogenannten B- oder C-Betrieb verwendet. Der Wirkungsgrad beträgt theoretisch 78,5 % für B-Betrieb. Bei B-Klasse-NF-Verstärkern werden praktisch Wirkungsgrade um 70 % erreicht. Die Restspannung und der Ruhestrom in den Endstufen bringen die zusätzlichen Verluste.

Sinkt der Modulationsgrad m einer amplitudenmodulierten hochfrequenten Schwingung unter 1, was beim Modulieren mit Musik und Sprache der Fall ist, so liegt der erreichbare Wirkungsgrad noch wesentlich tiefer. Bei tiefen Modulationsgraden bis ca. $m = 0,4$, welche bei Rundfunkprogramm-Modulation im Mittel erreicht werden, sind die Verluste gegenüber der abgegebenen Leistung relativ hoch ; der Wirkungsgrad eines Modulators mit einem B-Klasse-Verstärker liegt dann bei etwa 27 %.

Da die abgegebene NF-Leistung $P_{mod}$ eines Modulationsverstärkers dem Quadrat des Modulationsgrades proportional ist, $P_{mod} = P_T m^2/2$, $P_T$ = Leistung des Trägers, werden bei mittleren Modulationsgraden die Verluste bemerkbar, und der Gesamtwirkungsgrad eines Senders sinkt rapid im Bereich von $m = 0$ bis $m = 0,6$.

Zum Beispiel durch Eugen Philippow, Taschenbuch Elektrotechnik Bd. 3, VEB Verlag Technik Berlin 1978, S. 721, ist ein für Grossender verwendbarer Anoden-B-Modulator bekannt, bei dem die Modulationsspannung der Anodengleichspannung für die Leistungs-Endstufe überlagert wird. Die Amplitude der am Antennenausgang verfügbaren Ausgangswechselspannung ist dann der Anodenspannung nahezu proportional. Die Modulationsspannung wird von einem Modulationsverstärker im Gegentakt-B-Betrieb über einen Modulationstransformator zur Verfügung gestellt. Dabei liegen die Mittelanzapfung der Primärwicklung sowie ein Ende der Sekundärwicklung dieses Modulationstransformators auf einem konstanten Anodenpotential. Ein Nachteil dieses Anoden-B-Modulators besteht darin, dass bei niedrigem Modulationsgrad hohe Verluste auftreten, da dem Modulationsverstärker stets die volle Anodenspannung zugeführt ist.

Durch die DE-A-2 342 714 ist eine Gitter-Modulationsschaltung für Funksender bekannt, bei welcher die Anodenspannung der Endstufe eines Funksenders synchron mit der Aenderung der mittleren Leistung eines Modulationssignals geändert wird. Von einem Modulator, der über eine Treiberstufe mit dieser Endstufe in Steuerverbindung steht, wird gleichzeitig ein Steuersignal für einen steuerbaren Gleichrichter abgeleitet, an dessen Ausgang die gleitende Anodenspannung verfügbar ist.

Aus der GB-A 444 050 ist insbesondere ein NF-Gegentakt-Verstärker bekannt, bei dem sowohl über einen nichtlinearen Zwischenverstärker die Gittervorspannung, als auch über einen gesteuerten Gleichrichter die Anodenspannung der Endröhren in Einklang mit den Einhüllenden des NF-Signals verändert werden.

In beiden Fällen, in denen die Versorgungsspannung des Verstärkers, d. h. die Anodenspannung, gesteuert wird, treten dynamische Verzerrungen des Modulationssignals beim Verstärkungsprozess auf, wenn die Versorgungsspannung bei abrupten Aenderungen des Eingangssignals diesen Aenderungen nicht schnell genug nachgeführt wird.

Aufgabe der Erfindung ist es daher, den Wirkungsgrad von Verstärkern für elektrische NF-Signale zu verbessern, ohne übermässige, störende Verzerrungen im verstärkten Signal in Kauf zu nehmen.

Die Aufgabe wird bei einer Verstärkerschaltung der eingangs genannten Art durch die Merkmale aus dem Kennzeichen des Anspruchs 1 gelöst. Weiterbildungen der Erfindung sind in den abhängigen Ansprüchen beschrieben.

Der Vorteil der Erfindung besteht darin, dass beim Betreiben eines NF-Verstärkers Energie gespart werden kann. Diese Einsparung gewinnt insbesondere für Hochleistungsverstärker im Dauerbetrieb an Bedeutung. Der Aufwand für diese Einsparung ist vergleichsweise gering, da bei der Realisierung des Erfindungsgegenstandes auf herkömmliche Schaltungsmittel zurückgegriffen werden kann.

Mit einer kontinuierlichen Anpassung der Versorgungsspannung an die momentane Amplitude der Modulationsspannung kann der Wirkungsgrad des Verstärkers bzw. Modulators derart erhöht werden, dass man bei Rundfunk-Programmodulation eines AM-Senders einen Gesamtwirkungsgrad erreicht, welcher dem eines pulsdauermodulierten (PDM-) Senders überlegen ist.

Zugleich werden dynamische Verzerrungen bei einer abrupten Aenderung der Amplitude des Eingangssignals klein gehalten, indem die gleitende Versorgungsspannung des Verstärkers einem Anstieg dieser Amplitude des Eingangssignals schnell und einem Abfall langsam nachgeführt wird. In dem in der Praxis des Betriebs von Rundfunksendern überwiegend verwendeten Bereich von Modulationsgraden bis etwa $m = 0,5$ können dynamische Verzerrungen ganz vermieden werden, indem die Versorgungsspannung bis zu einem Anfangswert, der diesem vorgebbaren Modulationsgrad entspricht, konstant gehalten und erst für höhere Werte des Modulationsgrades gleitend der Amplitude des Modulationssignals nachgeführt wird. Der Gesamtwirkungsgrad eines Senders kann somit bis etwa 50 % Modulationstiefe auf sehr hohen Werten gehalten werden, er beginnt erst über diesem Modulationsgrad stärker abzufallen. Im Bereich der Versorgungsgleitspannung können dynamische Verzerrungen durch Verwendung eines Verzögerungsgliedes in der Zuleitung des Modulationssignals zum Steuereingang des Verstärkers eliminiert werden.

Die Erfindung wird nachstehend anhand eines Ausführungsbeispieles beschrieben, wobei als Versorgungsspannung die verwendete Anodenspannung angesehen wird.

Es zeigen :

Figur 1 einen Anoden-B-Modulator mit gleitender Anodenspannung des Modulators,

Figur 2 ein Blockschaltbild des Gleitspannungs-Steuergerätes 15 von Fig. 1,

Figur 3 den Verlauf der Anodenspannung $U_{a1}$ eines Modulators gemäss Fig. 1 in Abhängigkeit vom Modulationsgrad m,

Figur 4 ein rechteckiges Burst-Signal $U_{mod}$ am Eingang des Gleitspannungs-Steuergerätes 15 von Fig. 1,

Figur 5 ein Impulsantwortsignal $U_{St}$ auf das Rechtecksignal gemäss Fig. 4 am Ausgang des Gleitspannungssteuergerätes 15 von Fig. 1 und

Figur 6 Gesamtwirkungsgrade η von Sendern in Abhängigkeit vom Modulationsgrad m für unterschiedliche Sendeleistungen und unterschiedliche Anodenspannungen des Modulationsverstärkers.

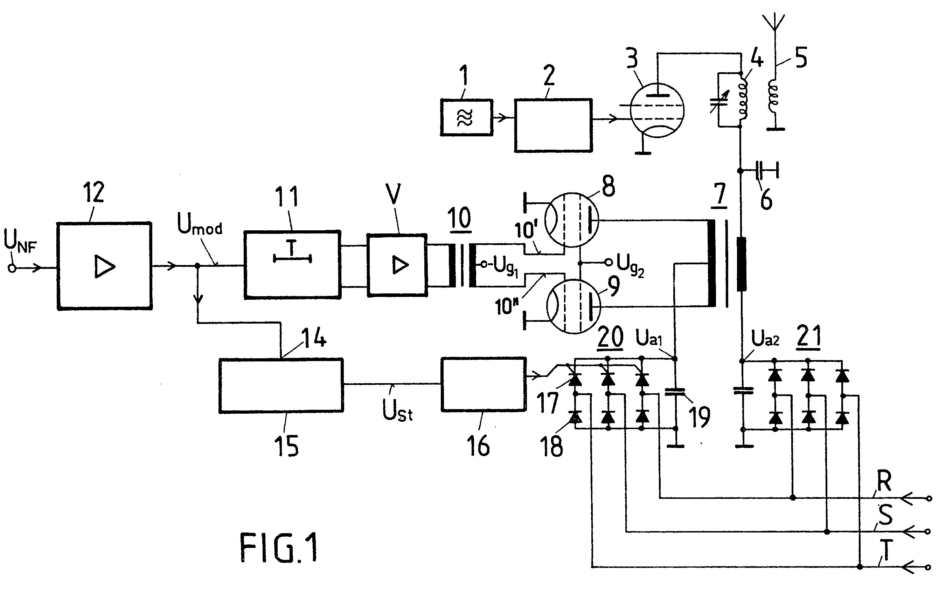

In Fig. 1 ist ein Amplitudenmodulator mit gleitender Anodenspannung gezeigt, der ausgangsseitig über einen Modulationstransformator 7 die Anodenspannung der HF-Endstufe eines Rundfunksenders moduliert. Diese HF-Endstufe weist eine als Leistungs- oder Endverstärker verwendete Tetrode 3 auf, die von einem Oszillator 1 über eine HF-Treiberstufe 2 gesteuert ist. Die Anode dieser Tetrode 3 ist über einen HF-Schwingkreis 4, der die Sendeleistung auf eine Antenne 5 überträgt, und über die Sekundärwicklung eines Modulationstransformators 7 mit einer Konstantspannungsquelle bzw. einem Hauptgleichrichter 21 verbunden, an dessen Ausgang die Spannung $U_{a2}$ anliegt. Zwischen dem Ausgang des HF-Schwingkreises 4 zur Sekundärwicklung des Modulationstransformators 7 und Erde bzw. Masse ist ein Siebkondensator 6 geschaltet, der eine Uebertragung der trägerfrequenten Schwingung von der HF-Endstufe auf den Amplitudenmodulator verhindern soll.

Der Amplitudenmodulator bzw. die zur Modulation der Anodenspannung der HF-Endstufe eines Senders verwendete Modulatorstufe weist im Gegentakt geschaltete Klasse-B-Verstärker bzw. Tetroden 8 und 9 auf, an deren Schirmgittern eine Spannung $U_{g2}$ anliegt und deren Steuergitter mit den Ausgängen 10' und 10" der Sekundärwicklung eines NF-Treibertransformators 10 verbunden sind. An der Mittelanzapfung der Sekundärwicklung dieses NF-Treibertransformators liegt die konstante Spannung $-U_{g1}$ an. Die Primärwicklung dieses NF-Treibertransformators ist über einen Verstärker V mit dem Ausgang eines Verzögerungsgliedes 11 verbunden, das ein diesem eingangsseitig zugeführtes Modulationssignal $U_{mod}$ um eine vorgebbare Zeitdauer T verzögert. Dieses Modulationssignal ist ein bereits in einem NF-Vorverstärker 12 verstärktes niederfrequentes Signal $U_{NF}$, das dem Eingang dieses Vorverstärkers zugeführt ist.

Das Modulationssignal $U_{mod}$ ist dem Eingang 14 eines Gleitspannungssteuergerätes bzw. einer Steuerstufe 15 zugeführt, die ausgangsseitig ein Steuersignal $U_{St}$ an eine Thyristorsteuerungsrichtung 16 liefert. In der Steuerstufe 15 wird der Betrag der Einhüllenden der in der Modulatorstufe zu verstärkenden elektrischen Signale gebildet.

Das Ausgangssignal der Thyristorsteuerungseinrichtung 16 ist dem Steuereingang von Thyristoren 17 zugeführt, die mit Dioden 18 in einer Drehstrombrückenschaltung angeordnet sind und den Modulator-Gleichrichter 20 bilden. Von dessen Ausgang ist die Verstärkerspannung bzw. Anodengleitspannung $U_{a1}$ für die Anoden der beiden Tetroden 8, 9 der Mittelanzapfung der Primärwicklung des Modulationstransformators 7 zugeführt. Ein parallel zur Gleichrichterstrecke geschalteter und einseitig geerdeter Kondensator 19 dient zur Glättung dieser Anodengleitspannung. Die Drehspannung für Haupt- und Modulator-Gleichrichter kommt über die mit R, S und T bezeichneten Phasenleitungen von einem nicht gezeigten Anodentransformator.

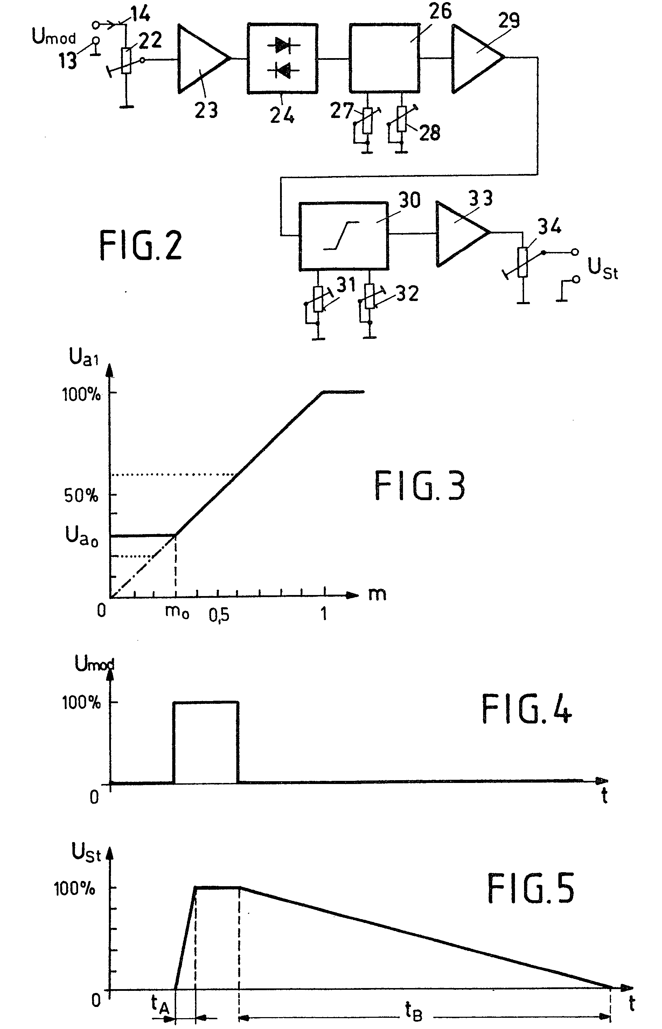

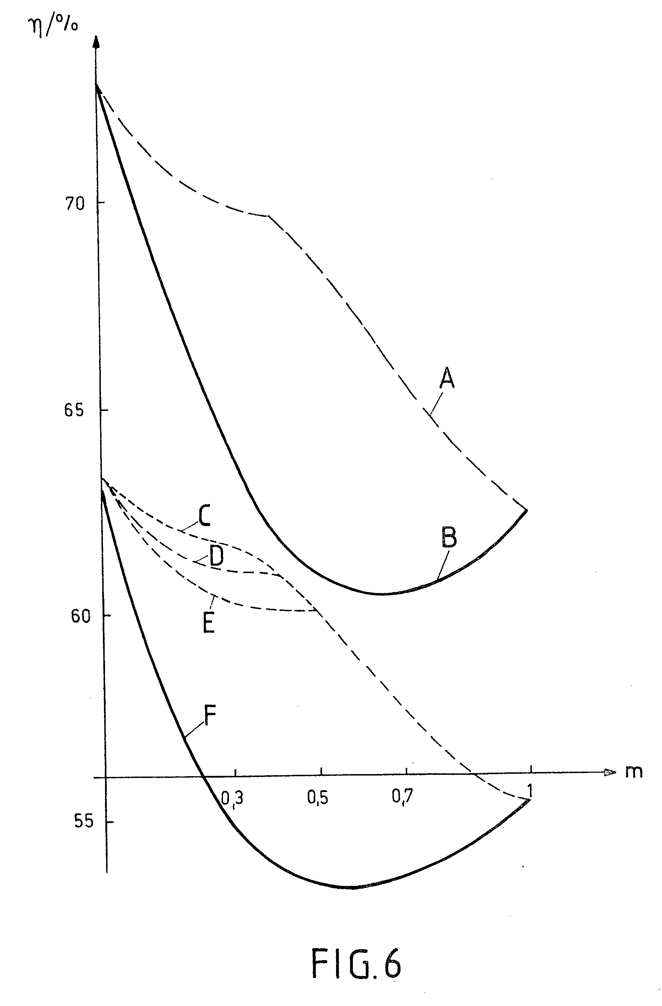

Fig. 2 zeigt ein Blockschaltbild dieser Steuerstufe 15. Das dem Eingang 14 zugeführte Modulationssignal $U_{mod}$ von z. B. 1 V Effektivspannung wird über ein Potentiometer 22 und einen Verstärker 23 einem Gleichrichter 24 zugeführt und gleichgerichtet. Zur Unterdrückung des Modulationssignals $U_{mod}$ in einem Anfangsbereich kann der Gleichrichter 24 mit einer einstellbaren, negativen Gleichrichtervorspannung im Bereich des 0,2-0,6-fachen der Gleichrichternennspannung (für m = 1) beaufschlagt werden. Die Eingangsklemme 13 ist geerdet. Das gleichgerichtete Modulationssignal ist über ein übliches Zeitglied 26, einem Verstärker 29, einen üblichen Begrenzer 30, einen weiteren Verstärker 33 einem einseitig geerdeten Potentiometer 34 zugeführt, an dessen Abgriff das Steuersignal $U_{St}$ anliegt. Mit dem Zeitglied 26 ist ein Potentiometer 27 mit geerdetem Abgriff zur Einstellung einer vorgebbaren Anstiegszeit $t_A$ von z. B. 1 ms und ein Potentiometer 28, ebenfalls mit geerdetem Abgriff, zur Einstellung einer vorgebbaren Abfallzeit $t_B$ im Bereich von 0,5 s-10 s, insbesondere von ≤ 3 s eines Impulsantwortsignals bzw. eines Ausgangssignals dieses Zeitgliedes bezüglich dessen Eingangssignal verbunden, vergleiche Fig. 5.

Der Begrenzer 30 steht mit Potentiometern 31 und 32 in Verbindung. Das Potentiometer 31 dient zur Einstellung eines vorgebbaren Maximalwertes entsprechend einem Bereich von m = 0,9 ÷ 1,1 des ausgangsseitig an der Steuerstufe 15 anliegenden Steuersignals $U_{St}$ und das Potentiometer 32 zur Einstellung eines Minimalwertes von $U_{St}$, entsprechend einem Bereich von m = 0,2 ÷ 0,6.

Das erfindungsgemässe Verfahren bzw. die Wirkung der Verstärkerschaltung sei nun anhand der Fig. 1-6 erläutert. Das zu verstärkende Niederfrequenzsignal $U_{NF}$ wird zunächst im NF-Vorverstärker 12 verstärkt und als Modulationssignal $U_{mod}$ über einen NF-Treiber, der ein Verzögerungsglied 11, einen Verstärker V und einen NF-Treibertransformator aufweist, den Steuergittern von im Gegentakt betriebenen Tetroden 8 und 9 zugeführt. Die Auskopplung des verstärkten Niederfrequenzsignals erfolgt über den Modulationstransformator 7, dessen Primärwicklung die Anodengleitspannung $U_{a1}$ für die beiden Tetroden zugeführt ist und dessen Sekundärwicklung im Anodenkreis mit konstanter Anodenspannung $U_{a2}$ der HF-Endstufe 3 eines Rundfunksenders liegt. Von dem Modulationssignal $U_{mod}$ wird in der Steuerstufe 15 ein Steuersignal $U_{St}$ abgeleitet, das der Amplitude der Einhüllenden des Modulationssignals entspricht, und zur Steuerung der Anodengleitspannung $U_{a1}$ verwendet. Diese Anodengleitspannung kann somit proportional zum Modulationsgrad m vergrössert werden. Für Modulationsgrade $m \geq 1$ liegt die volle Nennspannung des Modulatorgleichrichters an der Primärwicklung des Modulationstransformators und für einen Modulationsgrad m = 0 die Anodengleitspannung 0, falls keine Minimalspannung vorgegeben wird, vgl. die strichpunktierte Fortsetzung des geraden Teils der ausgezogenen Kurve im Bereich kleiner Werte von m in Fig. 3. Damit können ohne Modulation keine Anodenverluste in dem NF-Modulator auftreten.

Die ausgezogen dargestellte Kurve in Fig. 3 zeigt den Verlauf der Anodengleitspannung $U_{a1}$ am Ausgang des Modulator Gleichrichters 20 in Abhängigkeit vom Modulationsgrad m, welcher der Modulationsspannung $U_{mod}$ bzw. der Steuerspannung $U_{St}$ zugeordnet ist, gemäss einer bevorzugten Betriebsweise des NF-Modulators. Die Anodengleitspannung ist in Prozent der Anodennennspannung eingetragen. Bis zu einem mittels des Potentiometers 32, vgl. Fig. 2, vorgebbaren Anfangsmodulationsgrad $m_0$ von z. B. 0,3 wird dabei die Spannung am Ausgang des Modulator-Gleichrichters 20 konstant auf dem Wert der Anodenanfangsspannung $U_{a0}$ von z. B. 30 % der Anodennennspannung gehalten. Dies hat den Vorteil, dass im Modulationsbereich von 0 bis $m_0$ keine dynamischen Verzerrungen infolge einer verzögerten Nachführung der Anodenspannung $U_{a1}$ bezüglich des Modulationssignals eintreten können. Die gepunkteten Linien parallel zur Abzisse in Fig. 3 deuten vorgebbare unterschiedliche Anoden-Anfangsspannungswerte $U_{a0}$ an.

Die Fig. 4 und 5 zeigen das dynamische Verhalten der Steuerstufe 15. In Fig. 4 ist ein rechteckiges Burst-Signal $U_{mod}$ am Eingang dieser Steuerstufe und in Fig. 5 ein Impulsantwortsignal auf dieses Rechtecksignal am Ausgang von 15 dargestellt. Das Impulsantwortsignal folgt einem Anstieg des Eingangssignals verzögert innerhalb der Anstiegszeit $t_A$ und einem Abfall innerhalb der Abfallzeit $t_B$. Durch ein derartiges Zeitverhalten wird erreicht, dass nach Modulationspausen oder Perioden geringer Modulation bei abruptem Anstieg der Modulationsamplitude die Anodenspannung schnell nachgeführt und dynamische Verzerrungen niedrig gehalten werden. Dem abrupten Anstieg nachfolgende amplitudenstarke Modulationen werden praktisch verzerrungsfrei verstärkt, da die Steuerspannung $U_{St}$ und damit auch die Anodengleitspannung $U_{a1}$ eine gewisse Zeit lang auf hohem Potential bleiben und nur langsam abnehmen. Dabei wird eine gewisse niedrige Verlustleistung zugunsten eines vergleichsweise geringeren Klirrfaktors in Kauf genommen. Eine Verringerung der dynamischen Verzerrungen im Proportionalbereich der Anodengleitspannung wird durch eine Verzögerung des Modulationssignals im Verzögerungsglied 11 in der Zuleitung zu den Steuergittern der Tetroden 8 und 9 erreicht. Dabei wird die Verzögerungszeit T so eingestellt, dass sie wenigstens annähernd gleich der Verzögerung der Anodengleitspannung $U_{a1}$ bezüglich der zeitlichen Aenderung des Modulationssignals $U_{mod}$ ist.

Fig. 6 zeigt Gesamtwirkungsgrade $\eta$ von 2 Sendern im Klasse-B-Betrieb in Abhängigkeit vom Modulationsgrad m. Die Kurven A und B gelten für einen 600-kW-Mittelwellensender und die Kurven C-F für einen 250-kW-Kurzwellensender. Kurve A zeigt die Verbesserung des Wirkungsgrades mit einer Gleitspannung ab $m_0 = 0,4$ im Vergleich zu Kurve B, die für einen Betrieb ohne Gleitspannung, d. h. mit voller Nennspannung und einen Anodenruhestrom von 0,2 A gilt. Den Kurven C, D und E sind Gleitspannungen ab $m_0 = 0,3$; 0,4 und 0,5 zugeordnet. Sie zeigen die Wirkungsgradverbesserung gegenüber der Kurve F, die für einen Betrieb bei Nennspannung von 14 kV und einen Anodenruhestrom von 0,3 A gilt (Anodenrestspannung = 1,6 kV). Aus diesen Kurven wird deutlich, dass gerade bei mittleren und niederen Modulationsgraden bis etwa 0,4, welche bei Programmodulation im Mittel erreicht werden, beachtliche Wirkungsgradverbesserungen erreichbar sind.

**Ansprüche**

1. Verstärkerschaltung für niederfrequente Modulationssignale ($U_{mod}$) eines Rundfunksenders, welche Schaltung wenigstens eine Verstärkerstufe (8, 9) mit gleitender Versorgungsspannung, einen steuerbaren Gleichrichter (20) zur Erzeugung dieser gleitenden Versorgungsspannung und eine Steuerstufe (15) zur Steuerung des Gleichrichters (20) in Abhängigkeit von und gleichsinnig mit der Einhüllenden des zu verstärkenden Modulationssignals ($U_{mod}$) enthält, dadurch gekennzeichnet, dass die Steuerstufe (15) ein Zeitglied (26) für eine vorgebbare Nachführzeit des Ausgangssignals ($U_{St}$) der Steuerstufe (15) gegenüber dem Modulationssignal ($U_{mod}$) aufweist.

2. Verstärkerschaltung nach Anspruch 1, dadurch gekennzeichnet, dass das Zeitglied (26) ein Einstellglied (27) für eine vorgebbare Anstiegszeit ($t_A$) und ein Einstellglied (28) für eine vorgebbare Abfallzeit ($t_B$) des Ausgangssignals ($U_{St}$) der Steuerstufe (15) aufweist, wobei die Anstiegszeit ($t_A$) ≤ 10 ms und die Abfallzeit ($t_B$) ≤ 3 s ist.

3. Verstärkerschaltung nach einem der Ansprüche 1 oder 2, dadurch gekennzeichnet, dass die Versorgungsspannung der Verstärkerstufe (8, 9) für Modulationsgrade m der Verstärkung von 0 bis zu einem vorgebbaren Wert ($m_0$) im Bereich von 0,2 bis 0,6 konstant gehalten ist und für grössere Modulationsgrade im wesentlichen proportional zum Modulationsgrad bis zur maximalen Spannung des steuerbaren Gleichrichters (20) bzw. der Versorgungsnennspannung einstellbar ist.

4. Verstärkerschaltung nach einem der Ansprüche 1 bis 3, dadurch gekennzeichnet, dass der Verstärkerstufe (8, 9) ein Verzögerungsglied (11) zur zeitlichen Verzögerung des zu verstärkenden Modulationssignals ($U_{mod}$) vorgeschaltet ist und die Verzögerungszeit (T) des Verzögerungsgliedes (11) der Verzögerung der gleitenden Versorgungsspannung bezüglich der zeitlichen Aenderung des Modulationssignals ($U_{mod}$) wenigstens annähernd gleich ist.

5. Verstärkerschaltung nach einem der Ansprüche 1 bis 4, dadurch gekennzeichnet, dass die Verstärkungsstufe (8, 9) als röhrenbestückter Gegentakt-B-Modulationsverstärker mit einem Modulationstransformator (7) ausgebildet ist und die Versorgungsspannung von dem steuerbaren Gleichrichter (20) als Anodenspannung ($U_{a1}$) über eine primärseitige Mittelanzapfung des Modulationstransformators (7) eingespeist wird.

## Claims

1. An amplifier circuit for low-frequency modulation signals ($U_{mod}$) of a radio transmitter which circuit contains at least one amplifier stage (8, 9) having a variable supply voltage, a controllable rectifier (20) for generating this variable supply voltage and a control stage (15) for controlling the rectifier (20) in dependence on and in the same direction as the envelope of the modulation signal ($U_{mod}$) to be amplified, characterised in that the control stage (15) is provided with a timing element (26) for a predeterminable tracking time of the output signal ($U_{St}$) of the control stage (15) with respect to the modulation signal ($U_{mod}$).

2. An amplifier circuit according to Claim 1, characterised in that the timing element (26) is provided with an adjusting element (27) for a predeterminable rise time ($t_A$) and an adjusting element (28) for a predeterminable fall time ($t_B$) of the output signal ($U_{St}$) of the control stage (15), the rise time ($t_A$) being ≤ 10 ms and the fall time ($t_B$) being ≤ 3 s.

3. An amplifier circuit according to one of Claims 1 or 2, characterised in that the supply voltage of the amplifier stage (8, 9) is held constant for modulation factors m of the amplification from 0 up to a predeterminable value ($m_0$) within the range of 0.2 to 0.6 and can be adjusted for greater modulation factors essentially proportionally to the modulation factor up to the maximum voltage of the controllable rectifier (20) or of the nominal supply voltage.

4. An amplifier circuit according to one of Claims 1 to 3, characterised in that the amplifier stage (8, 9) is preceded in the circuit by a delay element (11) for delaying in time the modulation signal ($U_{mod}$) to be amplified and the delay time (T) of the delaying element (11) is at least approximately equal to the delay of the variable supply voltage with respect to the change in time of the modulation signal ($U_{mod}$).

5. An amplifier circuit according to one of Claims 1 to 4, characterised in that the amplifying stage (8, 9) is constructed as a class B push-pull modulation amplifier which is fitted with valves and with a modulation transformer (7) and that the supply voltage is supplied by the controllable rectifier (20) as anode voltage ($U_{a1}$) via a centre tap on the primary side of the modulation transformer (7).

## Revendications

1. Circuit amplificateur pour des signaux de modulation à basse fréquence ($U_{mod}$) d'un émetteur radio, qui comporte au moins un étage amplificateur (8, 9) à tension d'alimentation glissante, un redresseur pilotable (20) pour produire cette tension d'alimentation glissante et un étage de pilotage (15) pour piloter le redresseur (20) en fonction de l'enveloppe du signal de modulation ($U_{mod}$) à amplifier et dans le même sens que celle-ci, caractérisé en ce que l'étage de pilotage (15) présente un élément à temps (26) donnant une valeur pouvant être prédéterminée au temps dans lequel le signal de sortie ($U_{St}$) de l'étage de pilotage (15) suit le signal de modulation ($U_{mod}$).

2. Circuit amplificateur suivant la revendication 1, caractérisé en ce que l'élément à temps (26) présente un élément de réglage (27) pour un temps de montée ($t_A$) et un élément de réglage (28) pour un temps d'affaiblissement ($t_B$) pouvant être préétablis du signal de sortie ($U_{St}$) de l'étage de pilotage (15), étant entendu que le temps de montée ($t_A$) ≤ 10 ms et le temps d'affaiblissement $t_B$ ≤ à 3 s.

3. Circuit amplificateur suivant la revendication 1 ou 2, caractérisé en ce que pour des taux de modulation m de l'amplification allant de 0 à une valeur pouvant être préétablie ($m_0$) la tension d'alimentation des étages amplificateurs (8, 9) est maintenue constante dans le domaine compris entre 0,2 et 0,6 et pour des taux de modulation plus élevés, elle peut être réglée en substance proportionnellement au taux de modulation jusqu'à la tension maximale du redresseur (20) pouvant être commandé ou la tension nominale d'alimentation.

4. Circuit amplificateur suivant l'une quelconque des revendications 1 à 3, caractérisé en ce que l'étage amplificateur (8, 9) est précédé par un élément de retardement (11) destiné à retarder le signal de modulation ($U_{mod}$) à amplifier et le temps de retardement (T) de l'élément de retardement (11) est au moins approximativement égal au retardement de la tension d'alimentation glissante par rapport à la modification dans le temps du signal de modulation ($U_{mod}$).

5. Circuit amplificateur suivant l'une quelconque des revendications 1 à 4, caractérisé en ce que l'étage d'amplification (8, 9) a la forme d'un amplificateur de modulation push-pull-classe B équipé de tubes avec transformateur de modulation (7) et la tension d'alimentation du redresseur (20) pouvant être commandé est introduite en tant que tension d'anode ($U_{al}$) par l'intermédiaire d'une prise médiane située du côté du primaire du transformateur de modulation (7).

FIG.1

FIG.2

FIG.3

FIG.4

FIG.5

2

FIG.6